Europäisches Patentamt

(19) European Patent Office

Office européen des brevets

(11) Publication number: **0 384 616**
**A2**

# EUROPEAN PATENT APPLICATION

(21) Application number: **90301325.8**

(22) Date of filing: **08.02.90**

(51) Int. Cl.5: **H05K 3/00**

(30) Priority: **22.02.89 US 313912**

(43) Date of publication of application:
**29.08.90 Bulletin 90/35**

(84) Designated Contracting States:
**BE DE FR GB**

(71) Applicant: **DOW CORNING CORPORATION**
**3901 S. Saginaw Road**
**Midland Michigan 48686-0994(US)**

(72) Inventor: **Buentello, Manuel, III**
**8630 Boeing Drie, Suite 8**
**El Paso, Texas(US)**
Inventor: **Juen, Donnie Ray**
**2502 Peterson Drive**
**Sanford, Michigan(US)**
Inventor: **Vanwert, Bernard**
**2159 Old Pine Trail**
**Midland, Michigan(US)**

(74) Representative: **Horton, Sophie Emma et al**
**Elkington and Fife Beacon House 113**
**Kingsway**
**London WC2B 6PP(GB)**

(54) **Method for making electronic components using a masking material and a masking material therefor.**

(57) Electronic components are masked by dispensing over the portion to be protected an ultraviolet radiation curable elastomeric composition comprising a ultraviolet radiation curable polymer, photoinitiator and reinforcing silica filler. The deposited elastomeric composition is cured by exposure to ultraviolet radiation. The masked area is protected from contamination during solvent cleaning operations and flow soldering operations carried out in the manufacture of the electronic components. After the processing of the electronic components is completed the mask is removed and a clean usable area is exposed. The masking material is curable with ultraviolet radiation, solventless, thixotropic and elastomeric. It cures to a solvent resistant and thermal resistant material. The preferred masking material is a blend of two urethane acrylate oligomers, photoinitiator and reinforcing silica having a viscosity of 150 to 1,000 Pa·s at 25°C. when measured with a Brookfield spindle No. 4 at 0.5 rpm.

# METHOD FOR MAKING ELECTRONIC COMPONENTS USING A MASKING MATERIAL AND A MASKING MATERIAL THEREFOR

Electronic components are made today in large numbers and he industry is growing rapidly. The complexity of the devices and the desire to produce them at lower cost, is a strong driving force for the development of new methods of manufacturing the devices and for the development of new materials used to make them. In the manufacture of printed wire boards (PWB) or printed circuit boards (PCB), the need to mask various components such as connectors, stand offs, sockets, trim pots, chip carriers and switches can add substantially to the cost of manufacture. An investigation in methods to improve the cost of manufacture were undertaken and the results of that investigation lead to this invention.

This invention relates to a method for making an electronic component using a masking material comprising dispensing an ultraviolet radiation curable, solventless, thixotropic, elastomeric composition comprising a polymer which when exposed to ultraviolet radiation crosslinks to provide an elastomeric material, a photoinitiator and a reinforcing silica, on a substrate in at least one location to be masked, the composition flowing to cover only the location to be masked and remaining in that position until irradiated with ultraviolet radiation, irradiating the composition with ultraviolet radiation to cure it to a tack free, solvent resistant mask which remains in place during solvent cleaning operations and flow soldering operations and then removing the mask from the masked location of the substrate, in one piece, without leaving deposits of cured material behind and without otherwise damaging the substrate, said material being sufficiently thermally stable to withstand temperatures up to 1200° F for periods of less than 5 seconds.

This invention also relates to a masking composition useful in the method described above comprising a curable masking material for electronic components consisting essentially of a solventless, one package, dispensable, thixotropic, ultraviolet radiation curable material consisting essentially of (A) 40 to 60 parts by weight of a urethane acrylate prepolymer containing no reactive diluents, having a viscosity at 25° C. of 30 to 40 Pa•s, a number average molecular weight of about 5,000 and an acrylate functionality of two, (B) 40 to 60 parts by weight of urethane acrylate oligomer mixture containing 85 weight percent urethane acrylate oligomer and 15 weight percent tripropylene glycol diacrylate, where the oligomer has a number average molecular weight of about 1,600 and a viscosity at 60° C. in the range of 2.8 to 4.2 Pa•s, (C) from 0.5 to 6 weight percent of a photoinitiator which is not corrosive to elements of electronic components, preferably of the photoinitiator is from 2.5 to 4.5 weight percent of 2-hydroxy-2-methyl-1-phenylpropan-1-one, where the weight percent is based on the combined weight of (A) and (B), and (D) from 1 to 10 weight percent of a reinforcing silica having a surface area greater than 150 m$^2$/g, where the weight percent is based on the combined weight of (A) and (B), where said composition has a viscosity at 25° C. of between 150 and 1,000 Pa•s as measured with a Brookfield spindle No. 4, HATD - 0.5 rpm.

This invention also relates to a method for making the masking material comprising a method of preparing a masking material for electronic components comprising blending at a temperature less than a temperature which will cause the ingredients to decompose a solventless, dispensable, thixotropic, ultraviolet radiation curable material consisting essentially of (A) 40 to 60 parts by weight of a urethane acrylate prepolymer containing no reactive diluents, having a viscosity at 25° C. of 30 to 40 Pa•s, a number average molecular weight of about 5,000 and an acrylate functionality of two, (B) 40 to 60 parts by weight of urethane acrylate oligomer mixture containing 85 weight percent urethane acrylate oligomer and 15 weight percent tripropylene glycol diacrylate, where the oligomer has a number average molecular weight of about 1,600 and a viscosity at 60° C. in the range of 2.8 to 4.2 Pa•s, (C) from 0.5 to 6 weight percent of a photoinitiator which is not corrosive to elements of electronic components, preferably the photoinitiator is from 2.5 to 4.5 weight percent of 2-hydroxy-2methyl-1-phenylpropan-1-one, where the weight percent is based on the combined weight of (A) and (B), and (D) from 1 to 10 weight percent of a reinforcing silica having a surface area greater than 150 m$^2$/g, where the weight percent is based on the combined weight of (A) and (B).

The method of this invention is fast, usable with many kinds of components such as connectors, stand offs, sockets, trim pots, chip carriers and switches including dip switches and produces components with clean areas where the mask is located. The masked locations are protected from contamination during initial processing through the conformal processing steps such as found in the manufacture of PWB's. The method of this invention provides a temporary protective coating for PC (printed circuit) edge card connectors or printed circuit boards during assembly processes.

The electronic components to be manufactured by the method of this invention have at least a portion which requires that it remain free from contamination, but where the remaining portion of the component requires processing which can cause contamination. The portion to remain free from contamination is masked with a material so that during additional processing, contamination is prevented. The masking material useful in the method of this invention is a unique material which is an ultraviolet radiation curable material. It is solventless, thixotropic and elastomeric. The masking material must be capable of being dispensed from a nozzle or tube at a sufficient rate to be useful for rapid production of the electronic components. The portion of the electronic component can be rather small such as one or two millimeters in width and length. It should be understood that the particular geometry in not a limiting feature of the present invention and the use of width and length measurements are merely presented for illustrative purposes. The illustration is used to provide an understanding that the dispensing apparatus can have an orifice which is very small, such as a needle orifice with an inside diameter of 0.152 mm (0.006 inch) and the amount of masking material which is deposited at any one location on an electronic component can be a small amount. This illustration also provides an understanding that the masking material has flow properties which makes it useful for the method of this invention. The masking material must be able to flow through a orifice or nozzle which is small enough to deposit a quantity of the material in a one or two millimeter portion. The masking material must also not flow beyond the desired boundaries, i.e., the masking material must have sufficient thixotropic properties so that once the exerting force used to dispense the masking material is removed, the masking material will flow only to the preselected dimensions and no further before the masking material can be irradiated with ultraviolet radiation to cause it to cure. The masking material must have thixotropic properties so that it will not flow into holes to depths which could cause difficulties in removal of the mask. The removal of the mask from the electronic component can be aided by forming a tab of the masking material on the mask. This tab can be a blob of masking material protruding away from the device or component so as to allow grasping for the purpose of lifting the mask from the component. This tab can be formed by allowing the masking material to flow in one direction more than in other directions, such as a gravity flow at the edge of a device or component before the masking material is cured by irradiation with ultraviolet radiation. The tab can also be formed by extruding material beyond the device.

The kind of dispensing equipment is not particularly critical, as long as, it can dispense a preselected amount of masking material in the preselected location on the component (or preselected portion of the component). The dispensing equipment must have the capability of forcing the masking material out of the orifice without destroying its thixotropic characteristic. The dispensing process can also be done by hand using a pressurized dispenser. Materials which have thixotropic characteristics are best dispensed through equipment which does not produce high shear during any pumping or forcing operation, because high shear can cause destruction of the thixotropic characteristic. After the masking material is dispensed from the dispensing orifice, it should be allowed to flow only to the predetermined boundaries and when it reaches these boundaries, the masking material is irradiated with ultraviolet radiation which has a wavelength, is of an intensity and for a time period sufficient to cure the particular masking material. The specific source of ultraviolet radiation is not critical per se, as long as, it will cure the composition to a tack free, solvent resistant material which will remain in place during solvent cleaning operations, as well as, flow soldering operations. Another characteristic of the cured masking material is that it has stable physical properties over a broad temperature range.

By the term "solvent resistant material", it is meant that the cured material does not change shape, swell soften, or loose it seal with the substrate. The loss of the seal with the substrate will be considered a failure of the masking material because this would allow contaminants to penetrate the area (location or portion) of the component which is to be protected, i.e. the main purpose of using a masking material is protecting an area. The term "does not change shape" means that the shape of the mask remains substantially constant during the operations such as solvent cleaning and flow soldering operations. A slight change which does not alter the purpose of the mask is not to be excluded but is well within the scope of this invention. Likewise the cured composition (masking material) may swell or soften slightly and still be within the scope of this invention. The intent is that the change in shape, swelling or softening will not interfere with the function of the masking operation o the electronic component during additional manufacturing processes. The masking material of this invention is to be resistant to solvents, such as isopropyl alcohol and fluorocarbon solvents such as Freon TF, Genesolv DFX, Freon TMS and Fluorinert.

After the manufacturing operations are completed and the masking material is no longer needed to protect the predetermined location on the electronic component, the masking material is removed. Removing the masking material from the substrate is an important operation. Tabs formed from the masking material makes the masks removal easier and more readily lends the removal operation to automation. The masking material must not leave deposits on the substrate, this is often called slivering and it must not otherwise damage the substrate. For example, if the masking material covers detailed elements of an electronic component, such as a switch of small size, the removal process must not damage the switch.

From the foregoing process requirements, the criticality of the masking material is shown. The masking material must be cured rapidly on demand by exposure to ultraviolet radiation so that it can be maintained in the desired configuration over the area of the component to be protected from contamination. The masking material must cure to a material with a tack free surface and must form a seal with the substrate so as not to allow contaminants to reach the areas to be protected. This means that the protected area will remain sealed against contaminants during further manufacturing steps in the production of electronic components. This seal must be sufficient to withstand such operations and still allow the making material to be removed from the electronic component without leaving material behind on the substrate and without damaging the component. These characteristics are often opposed to one another. In developing materials which have a sufficient seal, means increasing the adhesion, but increasing the adhesion means that the material will be more difficult ot remove from the substrate resulting in deposits being left behind or damaged elements of the electronic component during the removal step. Further the solvent resistance and thermal resistance are to be achieved with a solventless composition which cures to an elastomer. The composition is also ultraviolet radiation curable, thixotropic and dispensable from a small orifice. The masking material must also have sufficient thermal stability to withstand temperatures up to 1200° F. for periods of less than five seconds.

One preferred curable masking material useful in the above method of manufacturing an electronic component consists essentially of a solventless, one package, dispensable, thixotropic, ultraviolet radiation curable elastomeric material. This material is a composition consisting essentially of (A) 40 to 60 parts by weight of a urethane acrylate prepolyer containing an acrylate functionality of two with a number average molecular weight of about 5,000, a viscosity at 25° C. of 30 to 40 Pa·s and containing no reactive diluents, (B) 40 to 60 parts by weight of urethane acrylate oligomer mixture containing 85 weight percent urethane oligomer having a number average molecular weight of about 1,600 and a viscosity at 60° C. in the range of 2.8 to 4.2 Pa·s and 15 weight percent tripropylene glycol diacrylate, (C) from 0.5 to 6 weight percent of a photoinitiator which is not corrosive to elements of electronic components, preferably the photoinitiator is from 2.5 to 4.5 weight percent of 2-hydroxy-methyl-1-phenyl-propan-1-one, where the weight percent is based on the combined weight of (A) and (B) and (D) from 1 to 10 weight percent of a reinforcing silica having a surface area greater than 150 m²/g, where the weight percent is based on the combined weight of (A) and (B). This composition has a viscosity at 25° C. between 150 and 1,000 Pa·s measured with a Brookfield spindle No. 4, HATD at 0.5 rpm. The compositions are solventless and are one package storable and will remain stable for periods up to six months when packaged in a container which keeps out ultraviolet radiation. The compositions cure to elastomers which are defined for the purpose of this invention as having elongations at break of greater than 50%.

For the purposes of this invention, the term "oligomer" and "prepolymer" are interchangeable. Some examples of commercially available acrylated urethane oligomer are as follows: Ebecryl 230 and Ebecryl 4883 sold by Radcure Specialties of Virginia. Urethane acrylate prepolymer of (A) is illustrated by Ebecryl 230 which is 100 percent solids urethane acrylate prepolymer containing no reactive diluents, has a viscosity at 25° C. of 30 to 40 Pa·s, a number average molecular weight of about 5,000 and a functionality of two. Urethane acrylate oligomer mixture is illustrated by Ebecryl 4883 which is 85 weight percent urethane acrylate oligomer or prepolymer and 15 weight percent tripropylene glycol diacrylate, the oligomer has a number average molecular weight of about 1,600 and a viscosity at 60° C. in the range of 2.8 to 4.2 Pa·s.

The reinforcing silica is one which has a surface area of greater than 150 m²/g and can be illustrated by Cab-O-Sil MS-7 which has a surface area of 200 m²/g and is sold by Cabot Corp. of Philadelphia, Pennsylvania. The reinforcing silica can be present in an amount of from 1 to 10 weight percent based on the combined weight of (A) and (B), preferably in an amount of from 2.5 to 5 weight percent.

The above preferred masking composition has a photoinitiator, (D), 2-hydroxy-2-methyl-1-phenyl-propan-1-one, however, it is believed that other photoinitiators can also be used. The amounts should be adjusted to provide the cured properties as required by this invention. here the amount of 2-hydroxy-2-methyl-1-phenyl-propan-1-one ranges from 2.5 to 4 weight percent, the amount of some other photoinitiator may have a different range. The photoinitiator can be any of those which are known in the art to cure acrylates. However, neither the photoinitiator nor its by-products should be corrosive to the electronic materials which it will come in contact with during its use. The photoinitiators preferably do not include the halogenated photoinitiators because these are often too corrosive. Illustrative of the photoinitiators of this invention are 2,2-diethoxyacetophenone, benzoin methyl ether, benzoin ethyl ether, benzoin isopropyl ether, alpha-methylbenzoin, alpha-ethyl-benzoin, alpha-methyl benzoin methyl ether, alpha-phenylbenzoin, alpha-allylbenzoin, anthraquinone, methylanthraquinone, ethyl-anthraquinone, tertiary butylanthraquinone, benzil, diacetyl, benzaldehyde, acetophenone, benzophenone, omega-benzoin, 2,3-pentanedione, hydroxycyclohex-

4

ylphenyl ketone, hydroxymethyl phenylpropanone and xanthone. The photoinitiator is most often recommended to be used in amounts of from 0.5 to 6 weight percent of the composition and which are suitable to provide cure of the composition when it is exposed to ultraviolet radiation. For purposes of this invention, it is expected that the amounts required of other photoinitiators will be greater than one weight percent. The preferred photoinitiator 2-hydroxy-2-methyl-1-phenyl-propan-1-one is present in amounts of from 2.5 to 4 weight percent of the composition.

The viscosity of the composition to be particularly useful as a masking material should range from 150 Pa•s to 1,000 Pa•s where the composition is measured with a Brookfield spindle No. 4 at 25°C., HATD - 0.5 rpm, preferably the viscosity is from 300 Pa•s to 800 Pa•s with the best results observed at about 600 Pa•s. The thixotropic characteristic of the composition can be observed by changing the rpm at which the viscosity is measured. A viscosity drop is observed during the deposition of the masking material onto the substrate, however, the thixotropic characteristic is such that the flow of the deposited material will stay within the predetermined boundaries between the time of deposition to the time of cure when exposed to ultraviolet radiation.

The composition can be made by blending the ingredients (A)-(D) together in a mixer which will disperse the filler to make a homogeneous mixture. The ingredients are blended at a temperature of less than a temperature which will decompose the ingredients, preferably the temperature is near room temperature or is a temperature of at least ambient conditions found during the mixing operation. The mixing operation is done under shear conditions which will produce a homogeneous mixture, i.e. the silica filler is homogeneously dispersed throughout the mixture, preferably the mixing operation is at high shear. Mixing equipment which can produce the high shear include mixers, such as a 3-roll rubber mill or a Neulinger mixer. After the material is mixed, the viscosity will increase during storage, however, this may be such that a composition prepared having an initial viscosity of about 200 Pa•s may increase to a viscosity of about 600 Pa•s where it will plateau, stabilize.

Although the preferred composition was discovered to have the recited properties and be particularly useful in the process of this invention to make electronic components using a masking technique, other compositions may find utility as masking materials as long as they meet the requirements for the method.

The method of this invention, using the defined masking material, provides a more efficient process than other masking materials. The masking material cures rapidly and conforms to the geometry of the substrate (electronic component), thus lending it to an automation process for the manufacture of electronic components. The preferred masking material composition, at about 50 mm from the lamp, cures in about six seconds when exposed to a source providing 5080 watts per linear millimeter (200 watts per linear inch) of arc of ultraviolet radiation from a medium-pressure mercury vapor lamp for thicknesses of about 30 mils. The preferred composition can be cured in a thickness of between 10 and 100 mils in 10 seconds or less by exposure to a medium pressure mercury lamp at a distance of about 76 mm (three inches) from the lamp. A thickness of at least 10 mils for a mask in recommended because a thickness of less than 10 mils may not be removable in one piece from the masked location. The preferred masking material also has the characteristic that it can bridge rather large holes such as up to about 250 mils without penetrating to unacceptable depths. This method uses the masking material which protects the substrate in the portions covered by it with a seal sufficient to keep out the contaminants and still be removable from the substrate without leaving deposits or damaging the substrate, i.e. the masking material stays in place during processing, is flexible enough, strong enough and has low enough adhesion to the substrate to be removable in one piece. The masking material has sufficient tear strength and a low tear propagation to meet the requirements of the processing operation.

Some ingredients were observed to be undesirable in making masking materials which are useful in the method of this invention. Amines, such as N-methyldiethanolamine, which have been used in ultraviolet radiation curable compositions to increase the cure rate, were found to effect the flow characteristics undesirably. Acrylated epoxies did not really function when used in place of the urethane acrylate prepolymers.

The following examples are presented for illustrative purposes and should not be construed as limiting the present invention which is properly delineated in the claims. In the examples, "parts" refers to parts by weight and the viscosities were measured at 25°C. unless otherwise specified.

Example 1

In a Neulinger mixer (manufactured by Neulinger Kreuziger of Austria) containing an agitator, a dissolver blade and a wiper blade, 23.24 parts of urethane acrylate prepolymer (Ebecryl 4883), 23.24 parts of urethane acrylate oligomer (Ebecryl 230) and 3.03 parts of 2-hydroxy-2-methyl-1-phenylpropan-1-one (Darocur 1173) were mixed at 3 rpm for five minutes to provide a homogeneous mixture. At this point, 2 parts of reinforcing silica (Cab-O-Sil MS-7) was admixed with the homogeneous mixture at 3 rpm for five minutes to wet out the silica. An additional 2.01 parts of the silica was added and mixing was continued with the agitator at 3 rpm for another five minutes. The dissolver blade was turned on at 1500 to 1600 rpm for five minutes, the mixer was turned off and the filler was scraped down using the wiper blade, mixing was then continued with the agitator at 3 rpm and the dissolver blade at 1500-1600 rpm for 10 minutes, adding 23.24 parts of Ebecryl 4883 and 23.24 parts of Ebecryl 230 to the mixer and the mixing was resumed with the agitator at 3 rpm and the dissolver blade at 1500-1600 rpm. The resulting composition was stored in a container which was opaque to ultraviolet radiation.

A sample of the composition was deposited on a test substrate to provide a sample thickness of about 30 mils and exposed to a medium pressure mercury lamp providing 5080 watts per linear millimeter (200 watts per linear inch) of arc for six seconds at a distance of about 50 mm. The cured film had a durometer on the Shore A scale of 75, a tensile strength at peak of 6.8 MPa, an elongation at break of 107%; a Young's Modulus of 8.5 MPa, a linear coefficient of thermal expansion of .000281 in/in/$^\circ$ C. The composition was cured as described above on Valox (polyester thermoplastic) and Ryton (polyphenylene sulfide) substrates and the 90$^*$ peel adhesion test showed 0.68 kg (1.5 pound) pull and 0.45 kg (1.0 pound) pull respectively.

Example 2

In a mixing container, 48 parts of Ebecryl 4883, 48 parts Ebecryl 230 and 1 part of 2-hydroxy-2-methyl-1-phenylpropan-1-one was mixed at low shear between 5 and 10 minutes and then 1.5 parts of reinforcing silica (Cab-O-Sil MS-7) was added with mixing. The resulting mixture was agitated at low shear until the silica was wetted out and then the 1.5 parts of silica was added and agitation was continued for 15 to 20 minutes. This mixture was then passed through a 3-roll mill with a 2.5 mil gap. The final mixture was deaired by centrifugation for 20 minutes immediately after milling. When the mixture was allowed to set, the viscosity increased and was very difficult to deair. The viscosity was measured by Brookfield, factor 8000, HATD model using a #4 spindle at 0.5 rpm. The viscosity determined one day after the milling step was 349.6 Pa$^\bullet$s at 21$^\circ$ C. The viscosity measured 10 minutes later with a #6 spindle at 5 rpm was 195.6 Pa$^\bullet$s at 21$^\circ$ C. The thixotropic character was 1.79 (349.6/195.6). The viscosities measured 20 days after the first viscosity measurements were 479.2 Pa$^\bullet$s (0.5 rpm with a #4 spindle at 22$^\circ$ C.) and 310.4 Pa$^\bullet$s (5 rpm with a #4 spindle at 22$^\circ$ C.), a thixotropic character of 1.54. The viscosity measured 28 days after the first measurement was 614.4 Pa$^\bullet$s (0.5 rpm with a #4 spindle at 19$^\circ$ C.). A composition prepared as described here except that the silica was left out, resulted in a composition which had a viscosity at 19$^\circ$ C. of 120 Pa.s measure at 0.5 rpm with a #4 spindle.

A sample of this material cured as described in Example 1 gave a material with a tacky surface, however, curing this material under a nitrogen blanket resulted in a tack free surface.

Example 3

Masking compositions were prepared as described in Example 1 in which Ebecryl 4883 was present in an amount of 47.5 parts, Ebecryl 230 was present in an amount of 47.5 parts, Darocur 1173 was present in an amount of one part and Cab-O-Sil MS-7 was present in an amount of 3.96 parts. The viscosities were determined by Brookfield, HATD spindle #4 at 0.5 rpm in each case. The initial viscosity taken immediately after preparation was 262.4 Pa$^\bullet$s at 21$^\circ$ C. After one day the viscosity at 21$^\circ$ C. was 707.2 Pa$^\bullet$s. Those viscosities were measured on samples of material which was not deaired. After deairing, the viscosities were measured at different temperatures as follows: 11 days after preparation at 24$^\circ$ C., the viscosity was 380 Pa$^\bullet$s, 14 days after preparation at 44$^\circ$ C., the viscosity was 200.8 Pa$^\bullet$s, 14 days after preparation at 90$^\circ$ C., the viscosity was 123.2 Pa$^\bullet$s and 23 days after preparation at 22$^\circ$ C., the viscosity was 691.2 Pa$^\bullet$s.

A sample of the masking material was pumped through a one millimeter orifice using a 0.55 MPa air pressure gun to pump the material at a rate of 12.5 g/min. The viscosity was determined after it was pumped and was 373.8 Pa$^\bullet$s at 23$^\circ$ C. This dispensed masking material had a viscosity at 22$^\circ$ C. nine days later of 560.8 Pa$^\bullet$s.

Example 4

Compositions were prepared by varying the weight ratios of Ebecryl 4883 and Ebecryl 230. These compositions contain 2 weight percent Cab-O-Sil MS-7 and 2 weight percent Darocur 1173 and were prepared by hand mixing the ingredients. The amounts of Ebecryl 4883 and Ebecryl 230 were based on the combination being 100 parts. Each composition was cured as described in Example 1 and the comments observed are shown in the Table. As shown by the Table, compositions which contain from 40 to 60 parts Ebecryl 4883 and 60 to 40 parts Ebecryl 230 provided useful masking materials within the scope of this invention.

TABLE

| AMOUNT OF URETHANE ACRYLATE | | |
|---|---|---|
| EBECRYL 4883 | EBECRYL 230 | CURED CHARACTERISTICS |
| 90 | 10 | Too hard, breaks upon removal leaves slivers |
| 80 | 20 | Still too hard and leaves slivers |
| 70 | 30 | Still too hard and leaves slivers |
| 60 | 40 | Did not leave slivers and was useful as a masking material |
| 50 | 50 | Acceptable for a masking material in every test tried |
| 40 | 60 | Soft, but still acceptable as a masking material |

EXAMPLE 5

A rectangular connector having two rows of 18 holes each wherein each hole was about 10 mils across on one side and 36 connector pins on the other side to match the holes was coated with the composition of Example 1 over the side with the 36 holes to a thickness of about 50 mils. The coating was applied covering the holes and beyond the holes so that all the holes were completely sealed against contamination. The masking material was dispensed from a needle dispenser having orifice of 0.61 mm of (0.024 inch) inside diameter. A tab was formed on one end of the connector which served as a means of easy removal of the mask from the connector. The masking material flowed into the holes to a depth of about 20 mils. After the connector was masked, the composition was cured by exposure to a medium pressure ultraviolet radiation lamp at about 76 mm (three inches) for a period of 10 seconds. The connector was suitable for placing on a printed wire board which was then coated with a conformal coating. After the conformal coating was applied and cured, the mask was removed to expose uncontaminated connector holes through which connector pins could be inserted without concern that the holes were contaminated with conformal coating which could interfere with the transmission of the electrical signals. The masking material was removed in one piece without leaving any material in or around the holes on the connector. In a like manner, switches were coated with the masking material of Example 1, so that the switches were protected from contamination of solvent cleaning. Some parts of the switches can be damaged by the solvents used in the cleaning processes and need to be protected against exposure to the solvents.

**Claims**

1. A method for making an electronic component using a masking material comprising
dispensing an ultraviolet radiation curable, solventless, thixotropic, elastomeric composition comprising a polymer which when exposed to ultraviolet radiation crosslinks to provide an elastomeric material, a photoinitiator and a reinforcing silica, on a substrate in at least one location to be masked, the composition flowing to cover only the location to be masked and remaining in that position until irradiated with ultraviolet radiation,
irradiating the composition with ultraviolet radiation to cure it to a tack free, solvent resistant mask which remains in place during solvent cleaning operations and flow soldering operations, and then removing the mask from the masked location of the substrate, in one piece, without leaving deposits of cured material behind and without otherwise damaging the substrate, said material being sufficiently thermally stable to withstand temperatures up to 1200° F. for periods of less than 5 seconds.

2. The method for making an electronic component using a masking material according to claim 1 in which the composition flows covering the location to be masked and also flows to form a tab useful for removal of the mask from the substrate.

3. The method for making an electronic component using a masking material according to claim 1 in which the elastomeric composition is a solventless, one package, dispensable, thixotropic, ultraviolet radiation curable material consisting essentially of (A) 40 to 60 parts by weight of a urethane acrylate prepolymer containing no reactive diluents, having a viscosity at 25° C. of 30 to 40 Pa·s, a number average molecular weight of about 5,000 and an acrylate functionality of two, (B) 40 to 60 parts by weight of urethane acrylate oligomer mixture containing 85 weight percent urethane acrylate oligomer and 15 weight percent tripropylene glycol diacrylate, where the oligomer has a number average molecular weight of about 1,600 and a viscosity at 60° C. in the range of 2.8 to 4.2 Pa·s, (C) from 0.5 to 6 weight percent of a photoinitiator which is not corrosive to elements of electronic components, where the weight percent is based on the combined weight of (A) and (B), and (D) from 1 to 10 weight percent of a reinforcing silica having a surface area greater than 150 m²/g, where the weight percent is based on the combined weight of (A) and (B), where said composition has a viscosity at 25° C. of between 300 and 800 Pa·s as measured with a Brookfield spindle No. 4, HATD - 0.5 rpm.

4. A curable masking material for electronic components consisting essentially of solventless, one package, dispensable, thixotropic, ultraviolet radiation curable material consisting essentially of (A) 40 to 60 parts by weight of a urethane acrylate prepolymer containing no reactive diluents, having a viscosity at 25° C. of 30 to 40 Pa·s, a number average molecular weight of about 5,000 and an acrylate functionality of two, (B) 40 to 60 parts by weight of urethane acrylate oligomer mixture containing 85 weight percent urethane acrylate oligomer and 15 weight percent tripropylene glycol diacrylate, where the oligomer has a number average molecular weight of about 1,600 and a viscosity at 60° C. in the range of 2.8 to 4.2 Pa·s, (C) from 0.5 to 6 weight percent of a photoinitiator which is not corrosive to elements of electronic components, where the weight percent is based on the combined weight of (A) and (B), and (D) from 1 to 10 weight percent of a reinforcing silica having a surface area greater than 150 m²/g, where the weight percent is based on the combined weight of (A) and (B), where said composition has a viscosity at 25° C. of between 150 and 1,000 Pa·s as measured with a Brookfield spindle No. 4, HATD - 0.5 rpm.